# EUROPÄISCHE PATENTSCHRIFT

(11) **EP 1 446 826 B1**
(45) Veröffentlichungstag und Bekanntmachung des Hinweises auf die Patenterteilung: **07.06.2006**
(21) Anmeldenummer: 02782772.4
(22) Anmeldetag: 21.11.2002
(51) Int. Cl.: H01L 21/00

(54) **LAGEREINRICHTUNG**
STORAGE DEVICE
DISPOSITIF DE STOCKAGE

(30) Priorität: 23.11.2001 DE 10157192
(43) Veröffentlichungstag der Anmeldung: 18.08.2004
(73) Patentinhaber: Ortner C.L.S. GmbH, 01109 Dresden (DE)
(72) Erfinder: BUDACH, Karsten, 01309 Dresden (DE); ESSER, Heinz, Martin, 50170 Kerpen (DE); JARNIG, Hubert, 9062 Moosburg (AT)
(74) Vertreter: Bauer, Dirk
(86) Internationale Anmeldenummer: PCT/DE2002/004277
(87) Internationale Veröffentlichungsnummer: WO 2003/046954

(56) Entgegenhaltungen:
- EP-A- 0 848 413
- EP-A- 1 134 641
- WO-A-99/02436
- US-A- 5 980 183
- US-A- 6 079 927
- US-B1- 6 280 134

## Beschreibung

Die Erfindung betrifft eine Lagereinrichtung zur Lagerung von bei der Halbleiterfertigung verwendeten Produktbehältern zur Aufnahme von Wafer-Scheiben, wobei die Lagereinrichtung innerhalb eines Reinraums angeordnet und an ein innerbetriebliches Transportsystem für die Produktbehälter angeschlossen ist.

Derartige allgemein bekannte Lagereinrichtungen sind deshalb bei der Halbleiterproduktion erforderlich, weil die Prozeßzeiten der einzelnen Anlagen sich um Größenordnungen unterscheiden und daher eine Zwischenlagerung sowohl der Ausgangs- als auch der Zwischen- und Endprodukte innerhalb des Reinraums, in dem der Herstellungsprozeß abläuft, unerläßlich ist.

Bekannt für den Transport und die Lagerung von Wafer-Scheiben, d.h. Siliciumscheiben, wie sie als Ausgangsprodukte bei der Halbleiterfertigung verwendet werden, sind sowohl offene Behälter (für 200-mm-Scheiben auch Carrier genannt) als auch geschlossene Behälter, die im Falle von 300-mm-Scheiben als FOUP und im Falle von 200-mm-Scheiben als SMIF-Pods bezeichnet werden. Unter Wafer-Scheiben im Sinne der vorliegenden Erfindung sollen jedoch sämtliche im Rahmen der Halbleiterfertigung vorkommenden Ausgangs-, Zwischen- und Endprodukte verstanden werden.

Die bekannten Lagereinrichtungen, offenbart beispielsweise in der DE 102 07 112 A1, sind in der Regel als sogenannte Lagerschränke ausgeführt. Diese sind auf dem Reinraumboden aufgestellt und beanspruchen einen nicht unerheblichen Raum. Die Schränke sind insbesondere bei solchen für die Unterbringung von Carriern belüftet bzw. befiltert, um auch bei einer langen Lagerungszeit von beispielsweise mehreren Wochen oder Monaten auszuschließen, daß sich Partikel auf den Wafer-Scheiben ablagern können. Aus diesem Grunde wird ein Laminarstrom der Luft auch in den Lagerschränken erzeugt, von dem eventuelle Schmutzpartikel mitgenommen werden.

Um die durch die Lagereinrichtungen blockierte und für eigentliche Produktionszwecke somit nicht mehr zur Verfügung stehende Fläche zu minimieren, ist gemäß der DE 197 37 839 C2 und der DE 199 05 882 C2 vorgeschlagen worden, den Raum oberhalb des eigentlichen Reinraums zu Lagerzwecken zu verwenden. Die Erreichbarkeit des oberhalb des eigentlichen Fertigungsbereichs angeordneten Lagerraums wird mit Hilfe einer Senkrechtfördereinrichtung realisiert, die durch eine Schleuseneinrichtung hindurch führt. Letztere Schleuseneinrichtung ist deshalb erforderlich, weil unterschiedliche Druckniveaus zwischen Reinraum und darüber angeordnetem Plenum möglichst verlustfrei aufrechterhalten werden sollen.

Aus der DE 31 02 046 C2 ist ein transportabler Speicher für Werkstücke (beispielsweise für Zahnräder) bekannt, der nach Art eines verfahrbaren Werkstückmagazins entlang einer unter einer Decke befestigten Schienenkonstruktion im Wesentlichen horizontal bewegbar ist. Jeder Speicher bietet die Möglichkeit, eine Mehrzahl von Werkstücken vertikal übereinander gestapelt aufzunehmen und nach unten an eine Bearbeitungsmaschine abzugeben. Die bekannte Vorrichtung beinhaltet lediglich verfahrbare Speicher, so dass eine feste Ablage oder Aufhängung des Werkstückmagazins, wie dies beispielsweise für eine längere Lagerzeit sinnvoll bzw. erforderlich wäre, nicht möglich ist. Durch die vertikale Anordnung einer Vielzahl von Werkstücken übereinander ist ein selektiver Zugriff auf bestimmte Werkstücke innerhalb desselben Magazins nicht möglich; vielmehr muss der Werkstückvorrat eines Magazins sequentiell in einer fest vorgegebenen Reihenfolge abgearbeitet werden. Im übrigen wird die in der DE 31 02 046 C2 beschriebene Konstruktion in keiner Weise den an Reinraumsysteme zu stellenden Anforderungen gerecht, sondern stellt eine Speziallösung für einen typischen rein maschinenbaulichen Anwendungsfall dar.

Die US 5,980,183 A offenbart einen "Integrierten Pufferraum" und ein "Abgabe- und Lagersystem" mit integriertem Fördersystem, das zur Steigerung der Lagerkapazität ohne Erhöhung der Aufstandsfläche eine Mehrzahl von vertikal über einander angeordneten Lagerplätzen aufweist.

Die WO 99/02436 A1 offenbart ein "SMIF-Pod Lager-, Abgabe- und Bereitstellungssystem" mit einer Mehrzahl über einander an einer vertikalen Wand angeordneter Lagerplätze für Produktbehälter, die mittels eines auf vertikal verlaufenden Schienen verfahrbaren Greifroboters bedient werden.

Der Erfindung liegt die Aufgabe zugrunde, eine Lagereinrichtung vorzuschlagen, mit der unter Einhaltung der geforderten Reinraumkriterien eine platzsparende und kostengünstige Möglichkeit zur Lagerung von Produktbehältern in der Halbleiterfertigung möglich ist.

Ausgehend von einer Lagereinrichtung der eingangs beschriebenen Art wird diese Aufgabe erfindungsgemäß dadurch gelöst, daß die Lagerplätze in Form eines Flächenlagers oberhalb von Prozessmaschinen oder Transportgängen und unterhalb einer Reinraumdecke in Lagerreihen angeordnet sind, wobei zwischen zwei paarweise nebeneinander angeordneten Lagerreihen jeweils ein Verfahrweg vorhanden ist, der mindestens die Breite einer Lagerreihe aufweist und wobei die Produktbehälter innerhalb der Verfahrwege auf nahezu derselben Ebene verfahrbar sind, in der sie später in den Lagerreihen abstellbar bzw. aufhängbar sind.

Die Lagereinrichtung nach der Erfindung ist somit in Bereichen innerhalb des Reinraums angeordnet, die ohnehin zur Verfügung stehen, zu eigentlichen Produktionszwecken jedoch nicht genutzt werden. So bieten sich für die Lagereinrichtung insbesondere die Räume oberhalb von Prozeßmaschinen oder Transportgängen an, in denen die volle Raumhöhe normalerweise nicht für Produktions- oder Transportaufgaben genutzt wird oder werden kann. Die erfindungsgemäße Einrichtung stellt vorzugsweise ein sogenanntes Flächenlager dar.

Die erfindungsgemäße Lösung zeichnet sich dadurch aus, daß die Investitions- und Betriebskosten bei der Halbleiterfertigung reduziert werden, da dieselben Aufgaben wie bei Konzepten nach dem Stand der Technik nunmehr mit Hilfe von Reinräumen einer reduzierten Grundfläche und eines entsprechend reduzierten Volumens erfüllt werden können. Die Produktbehälter können innerhalb der Verfahrwege auf nahezu derselben Ebene verfahren werden, in der sic später in den Lagerreihen abgestellt bzw. aufgehängt werden Da die erfindungsgemäße Lagereinrichtung bei den gegebenen Produktbehältern lediglich eine vergleichsweise geringe Bauhöhe von ca. 800 bis ca. 1000 mm aufweisen muß, ist eine Vergrößerung der Höhe des Reinraumes nicht erforderlich, da der nach dem Stand der Technik bisher ungenutzte Raum unterhalb der Reinraumdecke in der Regel mindestens in dieser Höhe zur Verfügung steht. Der Abstand der Lagereinrichtung von der Reinraumdecke sollte dabei so klein wie erforderlich bemessen werden.

Eine besonders vorteilhafte Art der Befestigung der erfindungsgemäßen Lagereinrichtung besteht darin, daß diese von der Reinraumdecke abgehängt ist.

Eine Möglichkeit zur Unterbringung der Produktbehälter in der Lagereinrichtung besteht darin, daß die Produktbehälter mit ihrer Unterseite auf eine Aufstandsfläche abstellbar sind. Hierbei ist die Gefahr, daß Produktbehälter trotz der deckennahen Anordnung zu Boden stürzen können, ausgeschlossen, da die Wirkung der Schwerkraft die Produktbehälter in ihrer Lage hält.

Alternativ hierzu ist es möglich, die Produktbehälter mit an gegenüberliegenden Seiten angeordneten Gabelgreifern aufzuhängen, die mit Vorsprüngen unter die Unterseite der Produktbehälter greifen. Des weiteren besteht eine vorteilhafte Variante darin, die Produktbehälter mit einem an ihrer Oberseite angeordneten Flanschelement in Klauengreifern oder dem Produktbehälter anderweitig angepaßten Greiferelementen aufzuhängen. Bei beiden letztgenannten Varianten ist eine besonders gute Zugänglichkeit der gelagerten Produktbehälter von unten her möglich, was insbesondere bei einem möglichen Stromausfall von Vorteil ist. Bei den beiden letztgenannten Varianten der Produktbehälteraufhängung ist jedoch sicherzustellen, daß eine hinreichende Sicherheit gegenüber einem Absturz der Produktbehälter gewährleistet ist. So kann beispielsweise eine Halterung mittels Klauengreifern durch seitlich angeordnete Gabelgreifer die im Normalfall nicht direkt in Eingriff sind, zusätzlich gegen Absturz abgesichert werden.

Die Erfindung weiter ausgestaltend ist eine Portaleinrichtung vorgeschlagen, die entlang von zwei im Abstand parallel zueinander verlaufenden Längsschienen einer von der Reinraumdecke abgehängten Tragkonstruktion verfahrbar ist. In Kombination hiermit wird ergänzend noch eine in Längsrichtung der Portaleinrichtung verfahrbare Läufereinrichtung vorgeschlagen. Auf diese Weise wird eine Einrichtung erzielt, die jeden Punkt innerhalb eines durch die Längsschienen und die Portaleinrichtung definierten Rechtecks erreichbar ist.

Um innerhalb einer wie vorstehend beschriebenen Lagereinrichtung die Produktbehälter an ihren Lagerplätzen abzusetzen bzw. von dort wieder aufzunehmen, kann eine der Läufereinrichtung zugeordnete Hubeinrichtung für eine vertikale Bewegung der Produktbehälter vorgesehen sein. Unter reinraumtechnischen Gesichtspunkten eignet sich für eine solche Vertikalbewegung insbesondere ein Scherentisch, da hierbei Partikelemissionen weitestgehend vermieden werden.

Um das Eigengewicht der erfindungsgemäßen Lagereinrichtung zu minimieren, sollte diese aus Aluminium-Strangpreßprofilen (in Form von Hohlprofilen) aufgebaut sein.

Zur Erfüllung höchster Anforderungen an die Reinraumqualität empfiehlt es sich, daß die Portaleinrichtung oder die Läufereinrichtung jeweils mittels eines Linearmotors verfahrbar sind. Um die Partikelemissionen weiter zu reduzieren, ist es empfehlenswert, eine Versorgung des Antriebs durch bewegliche Leitungen zu ersetzen durch eine berührungslose Energieversorgung z.B. nach dem Induktionsprinzip (synchrones Langstator-Linearprinzip), wobei eine Akkupufferung zusätzlich möglich ist. Sind die Reinraumkriterien geringer angesiedelt, bietet sich als Alternative zu einem Linearmotor auch ein Zahnstangenantrieb an.

Außerdem ist noch vorgesehen, dass sich die Lagerplätze ausschließlich seitlich außerhalb eines durch die Längsschienen der Portaleinrichtung definierten Verfahrwegs befinden, wodurch die Konstruktion der Portaleinrichtung vereinfacht wird. Um die erfindungsgemäße Lagereinrichtung besonders vorteilhaft an ein ohnehin vorhandenes innerbetriebliches Transportsystem anzuschließen, wird schließlich noch vorgeschlagen, eine Übernahme- oder Übergabeeinrichtung zu dem innerbetrieblichen Betriebssystem in Verlängerung eines Verfahrweges unmittelbar neben der Lagereinrichtung anzuordnen. Von dieser Übernahme- bzw. Übergabeeinrichtung aus kann der weitere Transport der Produktbehälter dann sowohl in derselben Ebene, in der die Lagereinrichtung angeordnet ist, erfolgen, als auch in einer beliebigen anderen Ebene, wobei in diesem Fall sinnvollerweise zunächst ein Vertikalförderer, beispielsweise in Form eines Lifts, neben der Lagereinrichtung angeordnet ist.

Die Erfindung wird nachfolgend anhand mehrerer Ausführungsbeispiele von Lagereinrichtungen nach der Erfindung, die in der Zeichnung dargestellt sind, näher erläutert. Es zeigt:
- Fig. 1: eine Vorderansicht einer von einer Reinraumdecke abgehängten Lagereinrichtung;
- Fig. 2: eine Seitenansicht der Lagereinrichtung nach Figur 1;
- Fig. 3: eine Draufsicht auf die Lagereinrichtung nach Figur 1;
- Fig. 4 bis 8: den Vorgang der Überführung eines Produktbehälters von einem Lagerplatz zu einem innerbetrieblichen Transportsystem;
- Fig. 9: eine Seitenansicht eines Produktbehälters mit darunter angeordneter Hubeinrichtung;
- Fig. 10 bis 13: vier unterschiedliche Grundrisse von Lagereinrichtungen,
- Fig. 14: eine alternative Lagereinrichtung mit auf ihren Unterseiten in den Lagerplätzen abgestellten Produktbehältern,
- Fig. 15: eine perspektivische Ansicht von unten auf eine weitere Lagereinrichtung und
- Fig. 16: eine Vorderansicht der Einrichtung nach Figur 15.

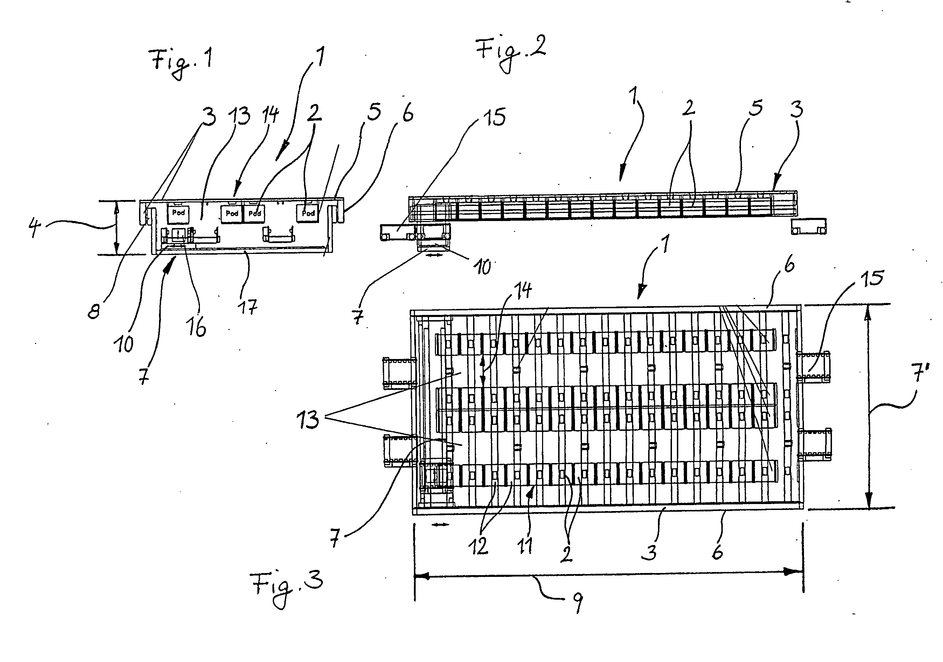

Die in den Figuren 1 bis 3 dargestellte Lagereinrichtung 1 dient zur Lagerung von Produktbehältern 2 (beispielsweise sogenannte FOUPS oder SMIF-Pods), die in der Halbleiterfertigung zur Aufnahme von sogenannten Wafer-Scheiben (Siliciumscheiben) verwendet werden. Da bei der Halbleiterfertigung extreme Bedingungen an die Sauberkeit der Atmosphäre, in der die Produktion abläuft, gestellt werden, findet sowohl der Herstellungsprozeß als auch die Lagerung unter Reinraumbedingungen statt. Die Lagereinrichtung 1 weist daher eine aus Aluminium-Strangpreßprofilen bestehende und an einer nicht dargestellten Reinraumdecke befestigte Tragkonstruktion 3 auf. Die Tragkonstruktion 3 und auch die Lagereinrichtung 1, deren Höhe 4 ca. zwischen 0,8m und 1,0 m beträgt, befindet sich mit ihrer Oberseite 5 (unmittelbar) unterhalb der Reinraumdecke. Unterhalb der Lagereinrichtung 1 können sich beispielsweise Produktionsmaschinen oder auch innerbetriebliche Verkehrsflächen befinden. Die Lagereinrichtung 1 nutzt somit Raum, der für andere Verwendungen bisher nicht genutzt wurde bzw. kaum zu nutzen ist.

Die Lagereinrichtung 1 umfaßt eine an Längsschienen 6 der Tragkonstruktion 3 befestigte Portaleinrichtung 7, die die Form eines nach oben offenen U's besitzt und sich nahezu über die gesamte Breite 7' der Lagereinrichtung 1 erstreckt. Mit Hilfe jeweils eines auf beiden Seiten der Portaleinrichtung 7 angeordneten Linearmotors 8 mit Führungseinheit ist die Portaleinrichtung 7 über die gesamte Länge 9 der Lagereinrichtung verfahrbar.

Die Portaleinrichtung 7 ist des weiteren mit einer in deren Längsrichtung verfahrbaren Läufereinrichtung 10 versehen, deren Antrieb gleichfalls mit Hilfe eines Linearmotors erfolgt, um auch höchsten Anforderungen an die Reinraumqualität gerecht zu werden. Bei geringeren Anforderungen an die Reinraumqualität kann sowohl der Antrieb der Portaleinrichtung 7 als auch der Läufereinrichtung 10 mit Hilfe von Zahnstangen erfolgen. Aufgrund der senkrecht zueinander verlaufenden Bewegungsrichtungen der Portaleinrichtung 7 und der Läufereinrichtung 10 läßt sich mit letzterer die gesamte Grundfläche der Lagereinrichtung 1 überstreichen.

Die in den Figuren 1 bis 3 gezeigte Lagereinrichtung weist vier in deren Längsrichtung verlaufende Lagerreihen 11 mit jeweils 15 hintereinander angeordneten Lagerplätzen 12 auf, die sämtlich mit Produktbehältern 2 belegt sind. Die Produktbehälter 2 können in den Lagerplätzen 12 aufgehängt, (seitlich) abgestützt oder abgestellt sein. Beidseitig von zwei mittig angeordneten und aneinander angrenzenden Lagerreihen 11 befindet sich ein Verfahrweg 13, an die sich jeweils die äußeren Lagerreihen anschließen. Die Breite 14 der Verfahrwege 13 ist breiter als die Breite der Produktbehälter 2, um deren Bewegung entlang der Verfahrwege 13 zu ermöglichen. Die Lagereinrichtung 1 ist über vier Lifteinrichtungen 14 mit einem innerbetrieblichen Transportsystem verbunden. Die Lifteinrichtungen 15 sind jeweils seitlich der Grundfläche der Lagereinrichtung 1, und zwar in beidseitiger Verlängerung der beiden Verfahrwege 13, angeordnet.

Die Läufereinrichtung 10 ist mit einer in vertikale Richtung verfahrbaren Hubeinrichtung 16 in Form eines Scherentischs versehen. Wie sich insbesondere aus Figur 1 ergibt, ist eine Quertraverse 17 der Portaleinrichtung 7 sowie die Läufereinrichtung 10 und die Hubeinrichtung 16 unterhalb der in ihren Lagerplätzen 12 befindlichen Produktbehälter 2 angeordnet.

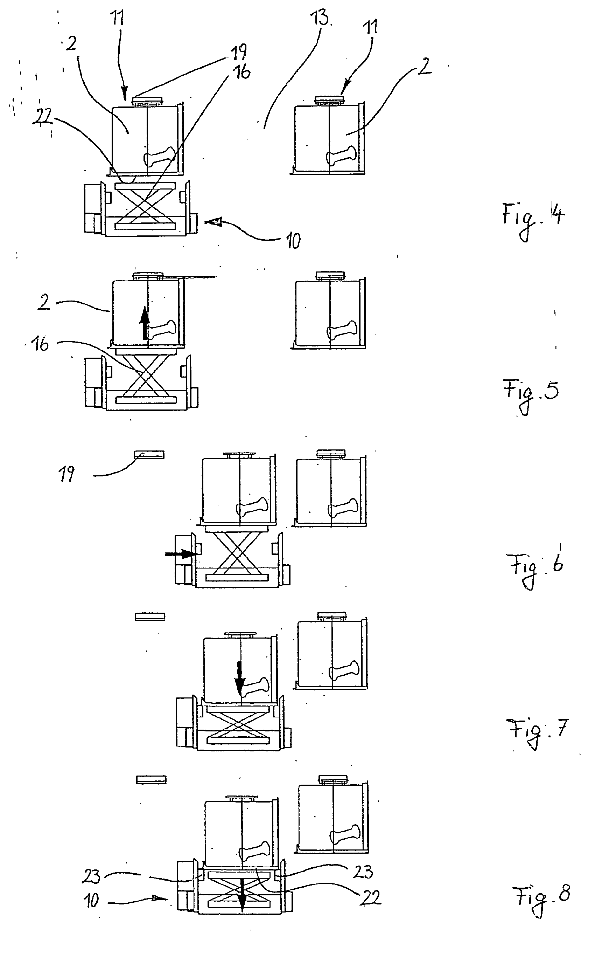

In den Figuren 4 bis 8 ist der Vorgang der Entnahme eines Produktbehälters 2 aus seiner Lagerposition gezeigt. Die Figuren 4 bis 8 zeigen zu diesem Zweck in einer Vorderansicht zwei Lagerreihen 11 mit einem dazwischen angeordneten Verfahrweg 13.

In Figur 4 befindet sich unterhalb der linken Lagerreihe 11 die Läufereinrichtung 10 mit der Hubeinrichtung 16 in einer teilweise ausgefahrenen Position. Aus Gründen der Übersichtlichkeit sind die Portaleinrichtung und die Tragkonstruktion nicht dargestellt. Die beiden Produktbehälter 2 (FOUP) befinden sich in ihren Lagerpositionen, in denen sie mit einem brückenförmigen Flansch 17 mit beidseitig überkragenden Randstreifen 18 in sogenannten Klauengreifern 19 hängen, die an der nicht dargestellten Reinraumdecke befestigt sind. Die Klauengreifer 19 besitzen im Querschnitt eine L-Form und stützen mit ihren horizontalen Schenkeln die überstehenden Randstreifen 18 der Flansche 17, die an der Oberkante 20 des Produktbehälters 2 befestigt sind, ab (Figur 9). Eine alternative Befestigungsmöglichkeit zu den Klauengreifern 19 stellen die gleichfalls in Figur 9 dargestellten Gabelgreifer 21 dar, die wiederum an der nicht dargestellten Reinraumdecke befestigt sind und sich seitlich neben dem Produktbehälter 2 erstrecken. Die Gabelgreifer 21 stützen den Transportbehälter 2 mit seitlichen Vorsprüngen an dessen Unterseite 22 ab. Die Aufhängung der Produktbehälter 2 erfolgt alternativ entweder mittels Klauengreifern 19 oder mittels Gabelgreifern 21.

In Figur 5 ist dargestellt, wie die Hubeinrichtung 16 so weit angehoben wurde, daß sie mit der Unterseite 22 des Transportbehälters 2 in Kontakt kommt. Ausgehend von dieser Kontaktposition wird die Hubeinrichtung 16 noch um weitere ca. 3 bis 5 mm angehoben, um den Flansch 17 außer Eingriff mit den Klauengreifern 19 zu bringen. Ausgehend von dieser Aushebeposition kann die Läufereinrichtung 10 zusammen mit der Hubeinrichtung 16 und dem abgestützten Produktbehälter 2 entlang der Portaleinrichtung 7 in die in Figur 6 dargestellte Position verfahren werden. Der Produktbehälter 2 befindet sich nunmehr in dem Verfahrweg 13 und kann nunmehr in Längsrichtung der Lagereinrichtung 1 bewegt werden. Bei dieser Bewegung befindet sich der Produktbehälter 2 in einer abgesenkten Position (Figur 7), in der er jedoch noch vollständig von der Hubeinrichtung 16 abgestützt wird und daher sicher transportiert werden kann.

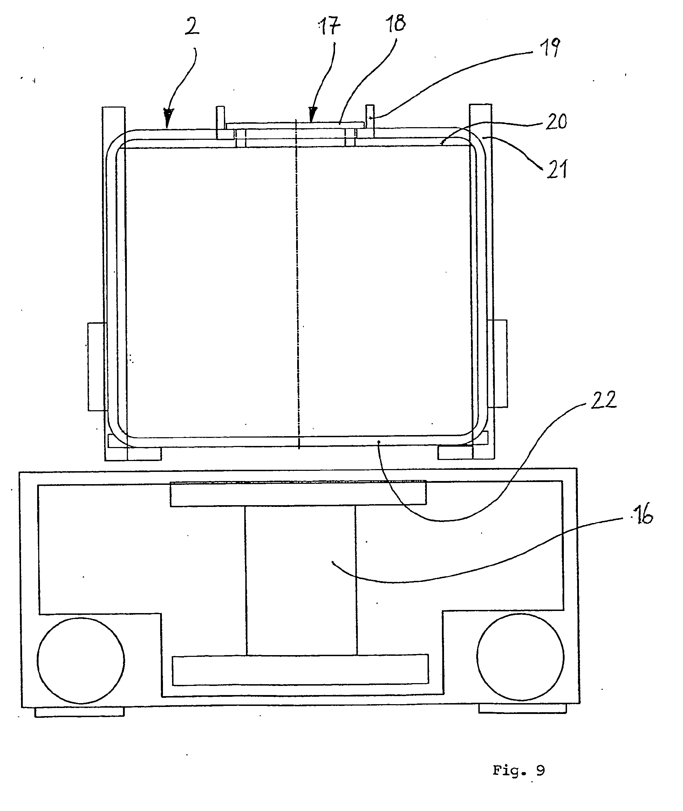

Aus Figur 8 ergibt sich, wie die Hubeinrichtung 16 nach Erreichen einer Endposition im Verfahrweg 13 weiter abgesenkt wird, so daß seitliche Randstreifen der Unterseite 22 des Transportbehälters 2 auf Rollen 23 eines in die Läufereinrichtung 10 integrierten Rollenförderers aufliegen. Durch Inbetriebsetzung der Rollen 23 läßt sich der Produktbehälter 2 nunmehr auf eine der Lifteinrichtungen 15 überführen, die jeweils gleichfalls mit einem Rollenförderer für den Horizontaltransport ausgestattet sind. Nach dieser Übergabe des Produktbehälters 2 an ein innerbetriebliches Transportsystem erfolgt der weitere Transport des Produktbehälters 2 beispielsweise zu einer Bearbeitungsmaschine.

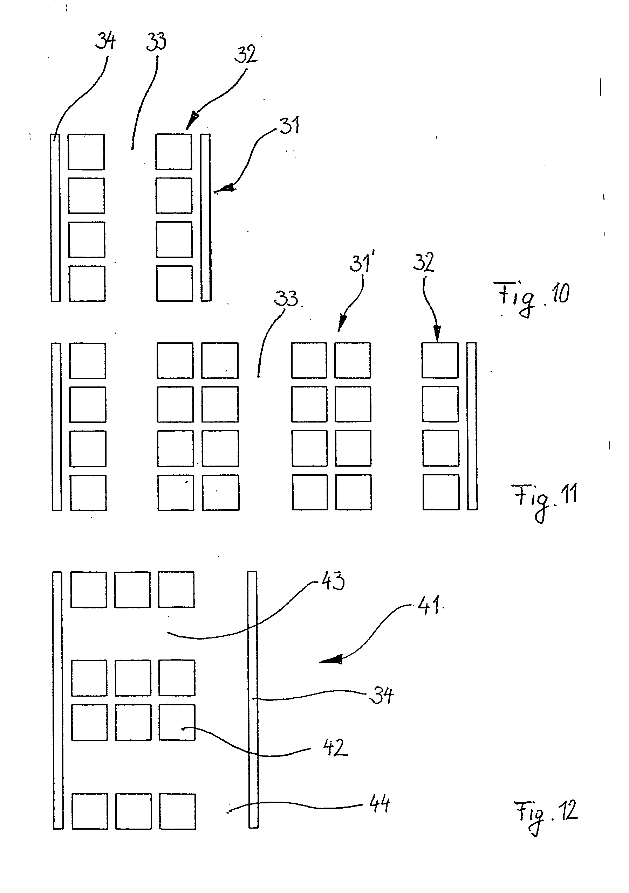

Figur 10 zeigt in einer Draufsicht den Grundriß einer Lagereinrichtung 31, die zwei Lagerreihen 32 und einen mittleren Transportweg 33 aufweist. Eine nicht dargestellte Portaleinrichtung ist entlang von Längsschienen 34 verfahrbar.

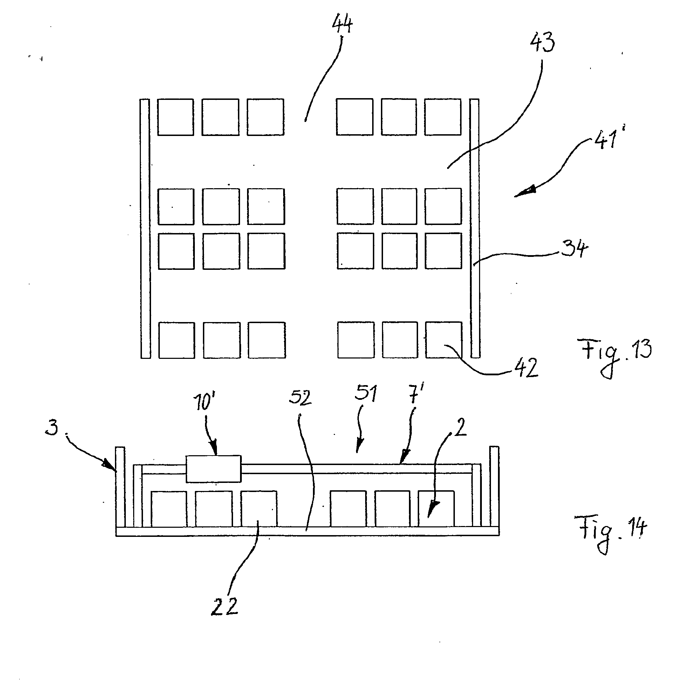

Im Vergleich hierzu weist die in Figur 11 abgebildete Lagereinrichtung 31' insgesamt sechs Lagerreihen 32 und drei Verfahrwege 33 auf, die insgesamt von einer einzigen Portaleinrichtung mit den Längsschienen 34 überspannt werden.

Im Gegensatz hierzu weisen die in den Figuren 12 und 13 dargestellten Lagereinrichtungen 41 und 41' Längsschienen 34 für eine Portaleinrichtung auf, die senkrecht zu den Lagerreihen 42 ausgerichtet sind. Das Lager 41' gemäß Figur 13 weist zwei senkrecht zu den Längsschienen 34 verlaufende Verfahrwege 43 und einen mittleren in Richtung der Längsschienen 34 verlaufenden Verfahrweg 44 auf. Dieser parallel zu den Längsschienen 34 verlaufende Verfahrweg 44 ist bei der Lagereinrichtung gemäß Figur 12 unmittelbar neben einer Längsschiene 34 angeordnet.

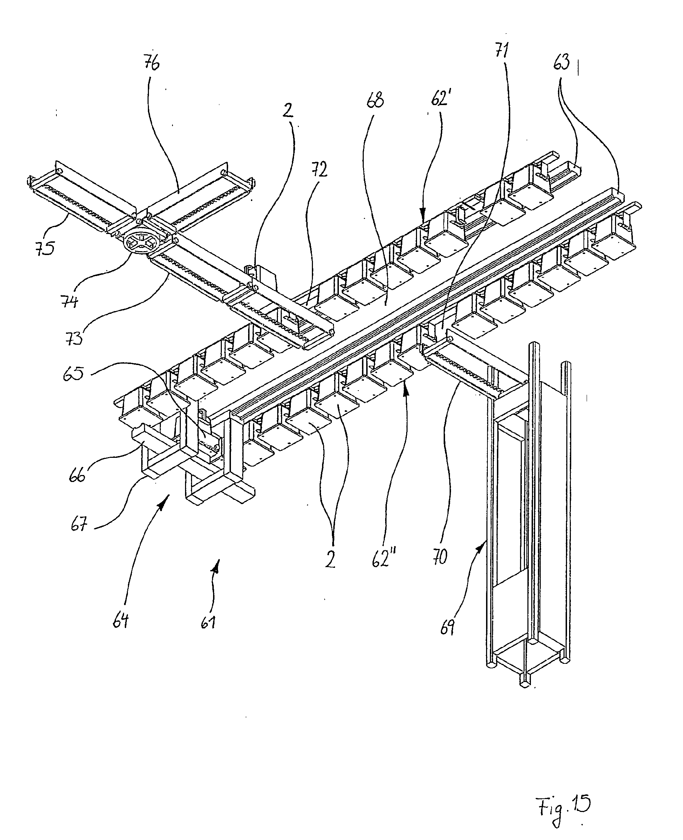

Außerdem ist in Figur 14 eine Lagereinrichtung 51 gezeigt, die eine wiederum von einer nicht dargestellten Reinraumdecke abgehängte Tragkonstruktion 3 in Form eines nach oben offenen U besitzt. Die hieran befestigte Portaleinrichtung 7' besitzt jedoch die Form eines nach unten offenen U, so daß sich die Läufereinrichtung 10' oberhalb der in ihrer Lagerposition befindlichen Produktbehälter 2 befindet. Diese sind mit ihren Unterseiten 22 auf einer Aufstandsfläche 52 angeordnet. Bei dieser Variante erübrigt sich eine "hängende" Lagerung jedes einzelnen Produktbehälters 2. Es ist jedoch schwieriger, die Produktbehälter 2 im Falle eines Ausfalls der Portaleinrichtung 7` oder der Läufereinrichtung 10` zu erreichen, da die Aufstandsfläche 52 die Zugänglichkeit der Lagerplätze von unten erschwert.

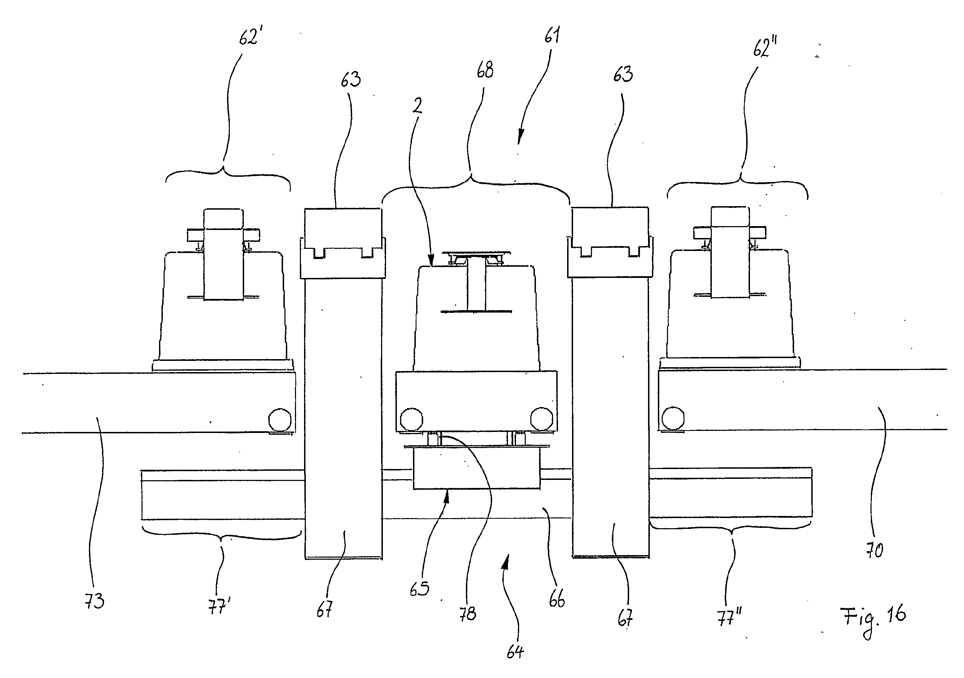

Schließlich ist in den Figuren 15 und 16 noch eine weitere Lagereinrichtung 61 dargestellt. Dabei zeigt Figur 15 eine Ansicht von unten auf die unter der Decke angeordnete Lagereinrichtung 61. Die Produktbehälter 2 sind in zwei parallelen Lagerreihen 62' und 62" angeordnet. Zwischen den beiden Lagerreihen 62' und 62" befinden sich zwei Längsschienen 63, entlang derer eine Portaleinrichtung 64 parallel zu den Lagerreihen 62' und 62" verfahrbar ist. Die Portaleinrichtung 64 ist wiederum mit einer senkrecht zu den Längsschienen 63 und in horizontale Richtung verfahrbaren Läufereinrichtung 65 versehen. Die Läufereinrichtung 65 ist entlang einer Tragschiene 66 verfahrbar und des Weiteren mit einer in Figur 15 nicht näher dargestellten Hubeinrichtung versehen, um die in den Lagerplätzen befindlichen Produktbehälter 2 anheben bzw. absetzen zu können. Die Tragschiene 66 stützt sich auf zwei U-förmigen Tragelementen 67 der Portaleinrichtung 64 so ab, dass Endabschnitte der Tragschiene 66 über die U-förmigen Tragelemente 67 auf beiden Seiten hervorragen. Die Portaleinrichtung 64 kann mit vergleichsweise geringem Aufwand hergestellt werden, da ihre Breite gering ist, weil die Längsschienen 63 und die darauf verfahrenen U-förmigen Tragelemente 67 innerhalb des Verfahrwegs 68 zwischen den benachbarten Lagerreihen 62' und 62" angeordnet sind.

Die Anbindung der Lagereinrichtung 61 an das übrige innerbetriebliche Transportsystem erfolgt im vorliegenden Fall auf einer Seite mittels einer senkrecht Fördereinrichtung 69, die über einen Abschnitt 70 einer horizontal angeordneten Rollenbahn an die Portaleinrichtung 64 bzw. die Läufereinrichtung 65 angebunden ist. Die Anbindung erfolgt an einer Stelle 71, an der sich ansonsten ein Lagerplatz für einen Produktbehälter 2 befinden würde.

In der gegenüberliegenden Lagerreihe 62' führt von einer Stelle 72 gleichfalls ein Abschnitt 73 einer horizontal verlaufenden Rollenbahn, auf der aus Anschauungsgründen ein Produktbehälter 2 abgebildet ist, in seitlicher Richtung von der Lagereinrichtung 61 weg. Der Abschnitt 73 der Rollenbahn verzweigt sich an einer Weicheneinrichtung 74 in zwei weitere Abschnitte 75 und 76, die Verbindungen zu anderen Bereichen in der Produktionshalle herstellen. In gleicher Weise ist auch die Senkrechtfördereinrichtung 69 im unteren Bereich an mindestens ein weiteres Transportsystem angebunden.

Figur 16 zeigt eine Vorderansicht der Lagereinrichtung 61, die sich unmittelbar unterhalb einer Decke eines Reinraumes befinden kann und sich typischerweise nicht in die Bereiche des Reinraums herab erstreckt, in dem sich auf dem Boden aufgestellte Bearbeitungsmaschinen befinden. Entlang zweier mit der Decke verbundener Längsschienen 63 sind U-förmige Tragelemente 67 verfahrbar. Quer zu den Tragelementen 67 verläuft die Tragschiene 66 auf der die Läufereinrichtung 65 verfahrbar ist. Im Bereich zwischen den Längsschienen 63 ist der Verfahrweg 68 für die Verschiebung der Produktbehälter 2 angeordnet. Die Konstruktion der Portaleinrichtung 64 ist besonders einfach, weil der Abstand der Längsschienen 63, d.h. auch die dazwischen befindliche Länge der Tragschiene 66, minimiert ist und nur unwesentlich größer zu sein braucht als die entsprechende Außenabmessung des Transportbehälters 2. Eine Erreichbarkeit der Lagerreihen 62 ' und 62" wird durch überkragende Abschnitte 77' und 77" der Tragschiene 66 ermöglicht. Um Produktbehälter 2 in den Lagerplätzen aufzunehmen bzw. dort abzusetzen wird die Läufereinrichtung 65 durch die von den U-förmigen Tragelementen 67 gebildeten Öffnungen hindurch in diese übertragenden Abschnitte 77' und 77" gefahren. Eine vertikale Verschiebung der Produktbehälter 2 auf der Läufereinrichtung 65 ist mit Hilfe zweier nur schematisch angedeuteter Hubeinrichtungen 78 möglich.

Des Weiteren ist in Figur 16 noch die Anbindung der Portaleinrichtung 64 an das übrige innerbetriebliche Transportsystem erkennbar und zwar in Form der Abschnitte 70 und 73 von Rollenbahnen, die anstelle von Lagerplätzen bis unmittelbar an die U-förmigen Tragelemente 67 herangeführt sind. Während der Transport auf den Rollenbahnen stehend erfolgt, geschieht die Aufhängung der Produktbehälter 2 in den Lagerplätzen hängend, wobei - wie bereits zuvor beschrieben - eine Aufhängung an einem oberen Flansch der Produktbehälter 2 mit Hilfe von Klauengreifern und aus Gründen einer Absicherung eine weitere (normalerweise inaktive) Aufhängung an seitlich angeordneten Klauengreifern erfolgt.

## Patentansprüche

1. Lagereinrichtung (1, 31, 3F, 41, 41', 51, 61) mit einer Mehrzahl von Lagerplätzen, in denen bei der Halbleitertertigung verwendete Produktbehälter (2) zur Aufnahme von Wafer-Scheiben lagerbar sind, wobei die Lagereinrichtung (1.31.31', 41, 41', 51, 61) innerhalb eines Reinraums angeordnet und an ein innerbetriebliches Transportsystem für die Produktbehälter (2) angeschlossen ist, **dadurch gekennzeichnet, daß** die Lagerplätze in Form eines Flächenlagers oberhalb von Prozessmaschinen oder Transportgängen und unterhalb einer Reinraumdecke in Lagerreihen (11, 32, 42, 62', 62") angeordnet sind, wobei zwischen zwei paarweise nebeneinander angeordneten Lagerreihen (11, 32, 42, 62', 62") jeweils ein Verfahrweg (13, 33, 43, 68) vorhanden ist, der mindestens die Breite einer Lagerreihe (11, 32, 42, 62', 62") aufweist und wobei die Produktbehälter (2) innerhalb der Verfahrwege (13, 33, 43, 68) auf nahezu derselben Ebene verfahrbar sind, in der sie später in den Lagerreihen (11, 32, 42, 62', 62") abstellbar bzw. aufhängbar sind.

2. Lagereinrichtung nach Anspruch 1, **dadurch gekennzeichnet, daß** sie von der Reinraumdecke abgehängt ist.

3. Lagereinrichtung nach Anspruch 1 oder 2, **dadurch gekennzeichnet, daß** die Produktbehälter (2) mit ihrer Unterseite (22) auf einer Aufstandsfläche (52) abstellbar sind.

4. Lagereinrichtung nach Anspruch 1 oder 2, **dadurch gekennzeichnet, daß** die Produktbehälter (2) mit an gegenüberliegenden Seitenflächen angeordneten Gabelgreifern (21) aufhängbar sind, die mit Vorsprüngen unter die Unterseite (22) der Produktbehälter (2) greifen.

5. Lagereinrichtung nach einem der Ansprüche 1 oder 2, **dadurch gekennzeichnet, daß** die Produktbehälter (2) mit an ihrer Oberseite angeordneten Flanschelementen (17) in Klauengreifern (19) aufhängbar sind.

6. Lagereinrichtung nach einem der Ansprüche 1 bis 5, **gekennzeichnet durch** eine Portaleinrichtung (7, 7',64), die entlang von zwei im Abstand parallel zueinander verlaufenden Längsschienen (6, 34,63) einer von der Reinraumdecke abgehängten Tragkonstruktion (3) verfahrbar ist.

7. Lagereinrichtung nach Anspruch 6, **gekennzeichnet durch** eine in Längsrichtung der Portaleinrichtung (7, 7',64) verfahrbare Läufereinrichtung (10, 10',65).

8. Lagereinrichtung nach Anspruch 7, **dadurch gekennzeichnet, daß** die Läufereinrichtung (10, 10',65) mit einer Hubeinrichtung (16,78) versehen ist.

9. Lagereinrichtung nach Anspruch 8, **dadurch gekennzeichnet, daß** die Hubeinrichtung (16) ein Scherentisch ist.

10. Lagereinrichtung nach einem der Ansprüche 1 bis 9, **dadurch gekennzeichnet, daß** die Tragkonstruktion (3) aus Aluminium-Strangpreßprofilen aufgebaut ist.

11. Lagereinrichtung nach einem der Anspruche 6 bis 10, **dadurch gekennzeichnet, daß** die Portaleinrichtung (7, 7',64) und/ oder die Läufereinrichtung (10, 10',65) jeweils mittels eines Linearmotors und/ oder eines Zahnstangenantriebs verfahrbar sind.

12. Lagereinrichtung nach einem der Ansprüche 6 bis 11, **dadurch gekennzeichnet, dass** sich die Lagerplätze ausschließlich seitlich außerhalb eines durch die Längsschienen (63) der Portaleinrichtung (64) definierten Verfahrwegs (68) befinden.

13. Lagereinrichtung nach Anspruch 1, **dadurch gekennzeichnet, daß** eine Übergabe-/Übernahmeeinrichtung des innerbetrieblichen Transportsystems in Verlängerung eines Verfahrwegs (13) unmittelbar neben der Lagereinrichtung (1) angeordnet ist.

## Claims

1. A storage device (1, 31, 31', 41, 41', 51, 61) with a plurality of storage places, in which product containers (2) used in semi-conductor production can be stored for receiving wafer disks, with the storage device (1, 31, 31', 41, 41', 51, 61) being arranged within a clean room and being connected to an in-plant transport system for the production containers (2), **characterized in that** the storage places are arranged in the form of a plane storage system above process machines or transport corridors and beneath a clean room ceiling in storage rows (11, 32, 42, 62', 62"), with a traveling path (13, 33, 43, 68) each being present between two storage rows (11, 32, 42, 62', 62") arranged in pairs next to each other, which traveling path has at least the width of a storage row (11, 32, 42, 62', 62"), and with the production containers (2) being movable within the traveling paths (13, 33, 43, 68) on virtually the same plane in which they will later be deposited or suspended in the storage rows (11, 32, 42, 62', 62").

2. A storage device according to claim 1, **characterized in that** it is suspended from the clean room ceiling.

3. A storage device according to claim 1 or 2, **characterized in that** the product containers (2) can be deposited with their bottom side (22) on a bearing surface (52).

4. A storage device according to claim 1 or 2, **characterized in that** the product containers (2) can be suspended with fork-type grippers which are arranged on opposite side surfaces and which grasp with projections beneath the bottom side (22) of the product container (2).

5. A storage device according to one of the claims 1 or 2, **characterized in that** the product containers (2) can be suspended in claw-type grippers (19) with flange elements (17) arranged on its upper side.

6. A storage device according to one of the claims 1 to 5, **characterized by** a portal device (7, 7', 64) which can be moved along two longitudinal rails (6, 34, 63) of a support construction (3) suspended from the clean room ceiling, which rails extend parallel with respect to each other at a distance from each other.

7. A storage device according to claim 6, **characterized by** a running device (10, 10', 65) displaceable in the longitudinal direction of the portal device (7, 7', 64).

8. A storage device according to claim 7, **characterized in that** the running device (10, 10', 65) is provided with a lifting device (16, 78).

9. A storage device according to claim 8, **characterized in that** the lifting device (16) is a lift table.

10. A storage device according to one of the claims 1 to 9, **characterized in that** the supporting structure (3) is made of extruded aluminum profiles.

11. A storage device according to one of the claims 6 to 10, **characterized in that** the portal device (7, 7', 64) and/or the running device (10, 10', 65) can each be moved by means of a linear motor and/or rack-and-pinion gear.

12. A storage device according to one of the claims 6 to 11, **characterized in that** the storage places are situated exclusively laterally outside of a path of displacement (68) defined by the longitudinal rails (63) of the portal device (64).

13. A storage device according to claim 1, **characterized in that** a transfer/receiving device of the in-plant transport system is arranged directly adjacent to the storage device (1) in extension of a path of displacement (13).

## Revendications

1. Système de stockage (1,31,31',41,41',51,61) avec une pluralité d'emplacements de stockage susceptibles de recevoir des récipients (2) utilisés dans la fabrication de semi-conducteurs et destinés à recevoir des plaquettes de semi-conducteurs en vue de leur stockage, le système de stockage (1, 31, 31', 41, 41', 51, 61) étant disposé dans une salle blanche et raccordé à un système de transport interne des récipients (2), **caractérisé en ce que** les emplacements de stockage sont disposés en rangées de stockage (11, 32, 42, 62', 62") sous forme de dépôt surfacique au-dessus de machines de traitement ou de couloirs de transport et en dessous d'un plafond de salle blanche, un chemin de déplacement (13, 33, 43, 68) ayant au moins la largeur d'une rangée de stockage (11, 32, 42, 62', 62") étant prévu entre deux rangées de stockage (11, 32, 42, 62', 62") disposées côte à côte par paires, les récipients (2) étant aptes à être déplacés sur les chemins de déplacement (13, 33, 43, 68) quasiment dans le même plan dans lequel ils seront ultérieurement aptes à être posés ou suspendus dans les rangées de stockage (11, 32, 42, 62', 62").

2. Système de stockage selon la revendication 1, **caractérisé en ce qu'**il est suspendu au plafond de la salle blanche.

3. Système de stockage selon la revendication 1 ou 2, **caractérisé en ce que** les récipients (2) sont aptes à être posés sur une surface (52) sur laquelle ils peuvent se tenir debout, en appui sur leur face inférieure (22).

4. Système de stockage selon la revendication 1 ou 2, **caractérisé en ce que** les récipients (2) sont aptes à être accrochés avec des préhenseurs à fourche (21) disposés sur des faces latérales situées en regard et dont les parties en saillie s'engagent sous la face inférieure (22) des récipients (2).

5. Système de stockage selon l'une quelconque des revendications 1 ou 2, **caractérisé en ce que** les récipients (2) sont aptes à être accrochés, par des éléments formant bride (17) disposés sur leur face supérieure, dans des préhenseurs munis de griffes (19).

6. Système de stockage selon l'une quelconque des revendications 1 à 5, **caractérisé par** un système à portique (7, 7', 64) apte à être déplacé le long de deux rails longitudinaux (6, 34, 63) distants et parallèles d'une structure porteuse (3) suspendue au plafond de la salle blanche.

7. Système de stockage selon la revendication 6, **caractérisé par** un système à coulisse (10, 10', 65) apte à être déplacé dans le sens de la longueur du système à portique (7, 7', 64).

8. Système de stockage selon la revendication 7, **caractérisé en ce que** le système à coulisse (10, 10', 65) est muni d'un mécanisme de levage (16, 78).

9. Système de stockage selon la revendication 8, **caractérisé en ce que** le mécanisme de levage (16) est une table élévatrice à pantographe.

10. Système de stockage selon l'une quelconque des revendications 1 à 9, **caractérisé en ce que** la structure porteuse (3) est constituée par des profilés extrudés en aluminium.

11. Système de stockage selon l'une quelconque des revendications 6 à 10, **caractérisé en ce que** le système à portique (7, 7', 64) et/ou le système à coulisse (10, 10', 65) sont aptes à être déplacés moyennant chacun un moteur linéaire et/ou un entraînement à crémaillère.

12. Système de stockage selon l'une quelconque des revendications 6 à 11, **caractérisé en ce que** les emplacements de stockage se situent tous sur le côté, en dehors d'un chemin de déplacement (68) défini par les rails longitudinaux (63) du système à portique (64).

13. Système de stockage selon la revendication 1, **caractérisé en ce qu'**un mécanisme de transfert du système de transport interne est disposé directement à côté du système de stockage (1) dans le prolongement d'un chemin de déplacement (13).
